# Europäisches Patentamt

# European Patent Office

# Office européen des brevets

(19)

(11) Numéro de publication: **0 145 602**
**B1**

(12) ## FASCICULE DE BREVET EUROPÉEN

(45) Date de publication du fascicule du brevet:
**23.11.88**

(51) Int. Cl.⁴: **G 01 R 13/20**

(21) Numéro de dépôt: **84402541.1**

(22) Date de dépôt: **10.12.84**

(54) Procédé de visualisation de grandeurs physiques variables dans le temps, et système permettant la mise en oeuvre de ce procédé.

(30) Priorité: **14.12.83 FR 8320038**

(43) Date de publication de la demande:
**19.06.85 Bulletin 85/25**

(45) Mention de la délivrance du brevet:
**23.11.88 Bulletin 88/47**

(84) Etats contractants désignés:
**AT BE CH DE GB IT LI LU NL SE**

(56) Documents cité:
**DE-A-2 013 056**
**FR-A-2 515 358**
**GB-A-2 052 077**

**TOUTE L'ELECTRONIQUE, no. 456, août-septembre 1980, pages 15-18, Paris, FR; Y. PACHEU: "Possibilités de l'oscilloscope "calculateur" "**
**ELEKTRONIK, vol. 22, no. 8, août 1973, pages 271-276, Munich, DE; K. LIPINSKI et al.: "Der rechnergesteuerte Oszillograf"**

(73) Titulaire: **ELECTRICITE DE FRANCE Service National, 2, rue Louis Murat, F-75008 Paris (FR)**

(72) Inventeur: **Janin, Paul, 52, Avenue Charles Péguy, F-95150 Taverny (FR)**
Inventeur: **Query, Jean- Louis Les Petites Malagones Bat.2, 15, Avenue de la Malagone, F-13009 Marseille (FR)**

(74) Mandataire: **Mongrédien, André, c/o BREVATOME 25, rue de Ponthieu, F-75008 Paris (FR)**

EP 0 145 602 B1

## Description

La présente invention concerne un procédé de visualisation de grandeurs physiques variables dans le temps, ainsi qu'un dispositif permettant la mise en oeuvre de ce procédé.

Elle s'applique notamment à la visualisation du graphe ou des graphes représentatifs de l'évolution des valeurs relatives de grandeurs physiques. L'invention s'applique aussi à la visualisation du graphe représentatif de l'évolution relative de grandeurs physiques par rapport au temps. Dans les deux applications citées ci-dessus, les valeurs de grandeurs physiques sont acquises en fonction du temps. Ce procédé et ce dispositif peuvent être utilisés notamment dans le contrôle du fonctionnement de toute installation dans laquelle des paramètres physiques sont mesurés périodiquement, en choisissant des fréquences d'échantillonnage prédéterminées; ces mesures permettent de suivre l'évolution du fonctionnement de cette installation au cours du temps, et éventuellement, d'intervenir en cas d'incident dans ce fonctionnement. C'est le cas par exemple, dans les réacteurs nucléaires où il est nécessaire de détecter tout déséquilibre axial de la puissance du réacteur afin d'y remédier efficacement. Ce déséquilibre est en fait détecté en suivant, au cours du fonctionnement, l'évolution de la valeur de la puissance du réacteur en fonction des valeurs du flux haut et du flux bas générés par le combustible. Le suivi constant de cette évolution permet notamment de commander le réacteur pour qu'il fonctionne à sa puissance maximale. Il permet aussi d'effectuer des variations rapides de puissance, comme par exemple la variation journalière de la charge. Cette commande consiste à modifier le niveau des barres de contrôle, dans la cuve du réacteur, ou la concentration d'acide borique.

On ne connaît pas actuellement de procédé et de système de visualisation de grandeurs variables dans le temps, avec lesquels il est possible de visualiser l'évolution des valeurs de l'une de ces grandeurs par rapport à l'évolution des valeurs d'une autre de ces grandeurs et/ou l'évolution des valeurs de l'une de ces grandeurs par rapport aux valeurs de l'autre grandeur, en fonction du temps, les valeurs de ces grandeurs étant fournies au départ, séparément, en fonction du temps. On ne connaît pas non plus de procédé ou de système qui permette de visualiser ces évolutions selon des échelles variables et selon des sélections périodiques variables de ces grandeurs évoluant l'une par rapport à l'autre et éventuellement par rapport au temps.

On connaît seulement des tables traçantes ou des systèmes de visualisations multicourbes qui ne permettent de représenter simultanément que les variations des valeurs de deux grandeurs physiques par rapport au temps. Ces procédés et ces systèmes ne permettent pas de représenter aussi les variations de l'une de ces grandeurs par rapport à l'autre et, éventuellement, par rapport au temps. Les procédés et les systèmes connus ne permettent de plus que très difficilement de faire varier la fréquence d'échantillonnage ou d'acquisition de ces grandeurs, de faire varier l'échelle de visualisation du graphe représentatif de leur évolution relative, et de faire varier aussi la fréquence de sélection des valeurs relatives de ces grandeurs, pour visualiser le graphe représentatif de cette évolution sur une période plus ou moins importante. Ces systèmes ne permettent pas de déterminer avec certitude les trajectoires suivies lors des variations de paramètres produisant des boucles.

Un système de ce type est décrit dans l'article: "Possibilités de l'Oscilloscope calculateur" de Y. PACHEU - Toute l'Electronique - Août/septembre 1980, N° 456, pages 15-18.

L'invention a pour but de remédier à ces inconvénients et notamment de permettre la visualisation de l'évolution relative des valeurs de grandeurs physiques, la fréquence d'échantillonnage ou d'acquisition de ces grandeurs ainsi que la fréquence de sélection des valeurs relatives de ces grandeurs étant réglables, et l'échelle de visualisation du graphe représentatif de l'évolution de ces grandeurs pouvant être elle-même choisie de façon prédéterminée.

L'invention vise tout d'abord un procédé de visualisation de grandeurs physiques variables dans le temps, consistant à enregistrer, avec au moins une fréquence d'échantillonnage ou d'acquisition prédéterminée, les valeurs de chacune de ces grandeurs au cours du temps, et caractérisé en ce qu'il consiste à enregistrer simultanément à la même fréquence d'échantillonnage l'évolution des valeurs de l'une de ces grandeurs par rapport à l'évolution des valeurs d'une autre de ces grandeurs et/ou l'évolution des valeurs de l'une de ces grandeurs par rapport à l'évolution des valeurs d'une autre de ces grandeurs, en fonction du temps, le procédé consistant ensuite à visualiser le ou les graphes représentatifs de la ou lesdites évolutions, le ou lesdits graphes étant visualisés à partir des valeurs enregistrées, sélectionnées en mémoire à la même fréquence que ladite fréquence d'échantillonnage prédéterminée, ou à partir de certaines des valeurs enregistrées sélectionnées avec une fréquence de sélection qui est multiple de la fréquence d'échantillonnage.

Selon une autre caractéristique, le procédé consiste en outre à appliquer à chacune des valeurs enregistrées des grandeurs, et avant visualisation, des coefficients de multiplication, pour obtenir, en relation avec le choix de chacun de ces coefficients, une échelle prédéterminée de visualisation ou desdits graphes.

L'invention a aussi pour objet un système de visualisation de grandeurs physiques variables dans le temps, comprenant un calculateur, une mémoire dans laquelle sont enregistrées les valeurs des grandeurs et reliée à ce calculateur, une horloge à fréquence réglable, reliée à des moyens d'acquisition des valeurs de ces grandeurs pour fixer au moins une fréquence d'échantillonnage ou d'acquisition des valeurs de ces grandeurs, des sorties de ces moyens d'acquisition étant reliées au calculateur, et des moyens de visualisation reliés au calculateur, caractérisé en ce qu'il comprend, en outre, des moyens reliés au calculateur pour commander l'enregistrement simultané dans la mémoire du calculateur et à la même fréquence, l'évolution des valeurs de l'une de ces grandeurs par rapport à l'évolution des valeurs d'une autre de ces grandeurs, ou l'évolution des valeurs de l'une de ces grandeurs par rapport à l'évolution des valeurs d'une autre de ces grandeurs en fonction du temps, le calculateur commandant les moyens de visualisation pour obtenir l'image du ou des graphes représentatifs de la ou desdites évolutions, à partir des desdites valeurs enregistrées.

Selon une autre caractéristique, le système comprend en outre des moyens pour appliquer à chacune des valeurs enregistrées, et avant visualisation, des coefficients de multiplication pour obtenir, en relation avec le choix de chacun des coefficients, une échelle prédéterminée de visualisation du ou desdits graphes.

Selon une autre caractéristique, ladite horloge réglable est en outre reliée au calculateur pour fixer la fréquence de sélection des valeurs enregistrées pour la visualisation desdits graphes, ces valeurs étant sélectionnées en mémoire avec une fréquence de sélection égale à la fréquence d'échantillonnage prédéterminée, ou avec une fréquence de sélection qui est multiple de la fréquence d'échantillonnage.

Selon une autre caractéristique, les moyens pour enregistrer les valeurs des grandeurs au cours de la ou desdites évolutions sont constitués par des tables de correspondance enregistrées en mémoire.

Selon une autre caractéristique, les moyens de multiplication sont constitués par des tables de multiplication par des coefficients, enregistrées en mémoire.

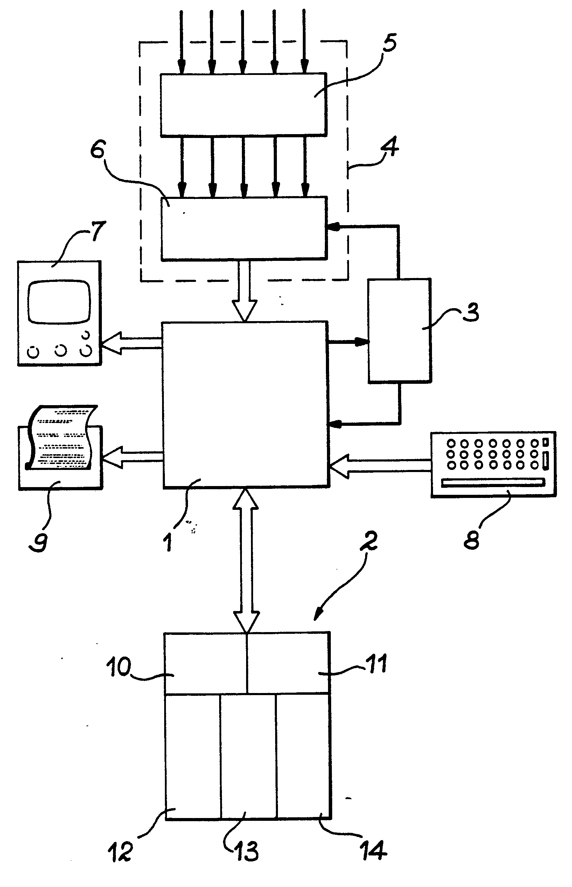

Les caractéristiques et avantages de l'invention ressortiront mieux de la description qui va suivre, donnée en référence à la figure annexée qui représente schématiquement un système d'enregistrement et de visualisation conforme à l'invention.

Le système de l'invention comprend un calculateur 1, une mémoire 2 reliée à ce calculateur, une horloge 3 à fréquence réglable, reliée au calculateur ainsi qu'à des moyens 4 d'acquisition de grandeurs physiques variables dans le temps. Les moyens d'acquisition 4 peuvent être constitués par exemple par un convertisseur analogique numérique 5 qui reçoit les grandeurs physiques variables et un multiplexeur 6 dont les sorties sont reliées au calculateur 1 et dont les entrées sont reliées à des sorties du convertisseur 5. L'horloge réglable 3 permet de fixer au moins une fréquence d'échantillonnage ou d'acquisition des valeurs des grandeurs fournies au calculateur 1 par le multiplexeur 6. La fréquence prédéterminée d'échantillonnage correspond à la fréquence d'enregistrement des valeurs des grandeurs physiques variables dans le temps, dans la mémoire 2. Le système comprend aussi des moyens de visualisation 7, de type cathodique par exemple. Ce système peut également comporter un clavier d'introduction de données 8 pour permettre notamment, de commander le réglage de la fréquence de l'horloge 3; une imprimante 9 peut également être reliée au calculateur 1.

Le système comprend aussi des moyens pour enregistrer simultanément dans la mémoire du calculateur et à la même fréquence que la fréquence d'échantillonnage, l'évolution des valeurs de l'une de ces grandeurs par rapport aux valeurs de l'autre grandeur, ou l'évolution des valeurs de l'une de ces grandeurs par rapport aux valeurs de l'autre et par rapport au temps. Le calculateur commande alors les moyens de visualisation pour obtenir le graphe représentatif de chacune de ces évolutions, comme on le verra plus loin en détail.

En fait, si l'on suppose par exemple que deux grandeurs x et y dont les valeurs varient en fonction du temps (t) ($x = f(t)$ et $y = g(t)$) sont acquises au départ, les moyens pour enregistrer l'évolution des valeurs relatives de ces grandeurs sont constitués par des tables 12, 13, localisées en mémoire. Ces tables permettent d'obtenir, pour la fréquence d'échantillonnage ou d'acquisition prédéterminée de ces grandeurs, soit l'évolution des valeurs de la grandeur x par rapport aux valeurs de la grandeur y, qui peut être notée $x = h(y)$ (évolution relative des valeurs de ces grandeurs), soit l'évolution des valeurs de la grandeur x par rapport aux valeurs de la grandeur y, et par rapport au temps t, cette évolution pouvant être notée $x = e(y, t)$. Les valeurs $x = f(t)$ et $y = g(t)$ fournies au calculateur 1 sous forme numérique par les moyens d'acquisition 4, peuvent être rangés respectivement dans les zones 10 et 11, de la mémoire vive 2; ensuite, les tables 12, 13 situées dans cette mémoire permettent d'établir les relations $x = h(y)$ et/ou $x = e(y, t)$. La fréquence d'échantillonnage ou d'acquisition des valeurs des grandeurs physiques fournies par les moyens d'acquisition 4, peut être à tout instant modifiée à l'aide du clavier d'entrée de données 8.

Le système comprend aussi des moyens pour appliquer simultanément à chacune des valeurs enregistrées des grandeurs, des coefficients de multiplication qui permettent d'obtenir, en relation avec le choix de chacun de ces coefficients, une échelle prédéterminée de visualisation des graphes représentatifs des évolutions des valeurs relatives des grandeurs acquises. Ces moyens sont constitués par une table 14 située dans la mémoire 2 du calculateur 1. Cette table permet à la fréquence d'échantillonnage choisie, d'appliquer un coefficient multiplicateur aux valeurs de la grandeur x et/ou aux valeurs de la grandeur y. Ce coefficient multiplicateur permet en fait d'agrandir ou de diminuer l'étendue du graphe visualisé sur l'écran des moyens de visualisation 7. En fait, alors que dans les systèmes de visualisation classiques, il est simplement possible de visualiser l'évolution par rapport au temps, des valeurs de grandeurs x et y séparément, le système de l'invention permet de représenter l'évolution des valeurs de la grandeur x par rapport aux valeurs de la grandeur y et, éventuellement l'évolution des valeurs de la valeur x par rapport aux valeurs y de la grandeur et par apport au temps t. Le clavier 8 permet également de modifier le coefficient de multiplication appliqué aux valeurs des grandeurs acquises. Cette multiplication est bien entendu effectuée avec la même fréquence que la fréquence d'échantillonnage prédéterminée.

L'horloge 3 est aussi reliée au calculateur pour visualiser avec le graphe x = h(y) et/ou le graphe x = e(y, t) avec une fréquence prédéterminée de sélection des valeurs relatives de ces grandeurs, fournies par les tables décrites plus haut. Cette fréquence de sélection peut être égale à la fréquence d'échantillonnage ou peut être un multiple de celle-ci. Lorsque la fréquence de sélection est égale à la fréquence d'échantillonnage, le graphe obtenu sur l'écran de visualisation représente l'évolution instantanée des valeurs relatives des grandeurs. Lorsque la fréquence de sélection est un multiple de la fréquence d'échantillonnage, le graphe obtenu sur l'écran de visualisation permet de suivre l'évolution dans le temps, des valeurs relatives des grandeurs. C'est ainsi par exemple que pour un processus dont la durée est importante (plusieurs heures par exemple), il est possible de ne sélectionner dans les tables de la memoire que les valeurs relatives des grandeurs correspondant à une acquisition qui serait effectuée toutes les cinq ou dix minutes par exemple, ou selon tout autre période prédéterminée.

Le procédé et le système de l'invention peuvent être appliqués par exemple au pilotage d'un réacteur nucléaire, à sa puissance maximale ou en cas de variation de charge. Dans ce cas, la puissance du réacteur est mesurée en fonction du temps et les données correspondantes sont acquises dans la mémoire du calculateur avec une fréquence d'échantillonnage prédéterminée. De la même manière, les données concernant le déséquilibre axial $\Delta \emptyset$ de la puissance, sont acquises en fonction du temps, avec la même fréquence d'échantillonnage. Le procédé et le système de l'invention permettent alors de visualiser le graphe représentatif de la variation de puissance du réacteur, en fonction de son déséquilibre axial de puissance. On ne décrira pas ici en détail les méthodes connues de mesures de la puissance et du déséquilibre axial d'un réacteur. Le graphe obtenu permet de suivre de manière instantanée ou au cours du temps, la puissance du réacteur en fonction du déséquilibre axial et ainsi, d'intervenir rapidement sur les moyens de contrôle de cette puissance; ce contrôle permet de maintenir le couple puissance-déséquilibre à l'intérieur d'un domaine de fonctionnement dont les limites sont calculées en temps réel par le calculateur. Avec les procédés et systèmes connus, l'intervention urgente n'est pas possible puisque l'opérateur doit, à partir du graphe représentatif de la puissance en fonction du temps et du graphe représentatif du déséquilibre axial de puissance en fonction du temps, consulter des abaques lui permettant de calculer à un instant donné la puissance en fonction du déséquilibre axial. Cette opération longue et donc préjudiciable ne permet pas d'intervenir rapidement sur les moyens de commande de la puissance du réacteur; de plus l'opérateur ne peut visualiser le graphe représentant cette évolution au cours du temps et ne peut donc conserver un historique du fonctionnement. Ces inconvénients disparaissent grâce au procédé et au système de l'invention.

**Revendications**

1. Procédé d'enregistrement et de visualisation de grandeurs physiques (x, y) variables dans le temps, consistant à enregistrer, avec au moins une fréquence d'échantillonnage ou d'acquisition prédéterminée, les valeurs (x = f(t), y = g(t)) de chacune de ces grandeurs au cours du temps, et caractérisé en ce qu'il consiste à enregistrer simultanément à la même fréquence d'échantillonnage, l'évolution des valeurs de l'une de ces grandeurs par rapport à l'évolution des valeurs d'une autre de ces grandeurs (x = h(y)) et/ou l'évolution des valeurs de l'une de ces grandeurs par rapport à l'évolution des valeurs d'une autre de ces grandeurs en fonction du temps (x = e (y,t)), le procédé consistant ensuite à visualiser le ou les graphes représentatifs de la ou lesdites évolutions, le ou lesdits graphes étant visualisés à partir des valeurs enregistrées, sélectionnées en mémoire à la même fréquence que ladite fréquence d'échantillonnage prédéterminée ou à partir de certaines des valeurs enregistrées sélectionnées en mémoire à une fréquence de sélection qui est multiple de la fréquence d'échantillonnage.

2. Procédé selon la revendication 1, caractérisé en ce qu'il consiste en outre à appliquer à chacune des valeurs enregistrées des grandeurs, et avant visualisation, des coefficients de multiplication, pour obtenir, en relation avec le choix de chacun de ces coefficients, une échelle prédéterminée de visualisation ou desdits graphes.

3. Système de visualisation de grandeurs physiques (x, y) variables dans le temps, comprenant un calculateur (1), une mémoire (2) dans laquelle sont enregistrées les valeurs des grandeurs et reliée à ce calculateur, une horloge (3) à fréquence réglable, reliée à des moyens d'acquisition (4) des valeurs de ces grandeurs pour fixer au moins une fréquence d'échantillonnage ou d'acquisition des valeurs de ces grandeurs, des sorties de ces moyens d'acquisition (4) étant reliées au calculateur (1), et des moyens de visualisation (7) reliés au calculateur, caractérisé en ce qu'il comprend, en outre, des moyens (12, 13) reliés au calculateur pour commander l'enregistrement simultané dans la mémoire (2) du calculateur et à la même fréquence d'échantillonnage de l'évolution des valeurs de l'une de ces grandeurs par rapport à l'évolution des valeurs d'une autre de ces grandeurs (x = h(y)), ou de l'évolution des valeurs de l'une de ces grandeurs par rapport à l'évolution des valeurs d'une autre de ces grandeurs en fonction du temps (x = e(y,t)), le calculateur (1) commandant les moyens de visualisation (7) pour obtenir l'image du ou des graphes représentatifs de la ou desdites évolutions, à partir desdites valeurs enregistrées.

4. Système selon la revendication 3, caractérisé en ce qu'il comprend en outre des moyens (14) pour appliquer à chacune des valeurs enregistrées, et avant visualisation, des coefficients le multiplication pour obtenir, en relation avec le choix de chacun des coefficients, une échelle prédéterminée de visualisation du ou desdits graphes.

5. Système selon la revendication 3, caractérisé en ce que ladite horloge réglable (3) est en outre reliée au calculateur (1) pour fixer la fréquence de sélection des valeurs enregistrées pour la visualisation du ou desdits graphes, ces valeurs étant sélectionnées en mémoire avec une fréquence de sélection égale à la fréquence d'échantillonnage prédéterminée, ou avec une fréquence de sélection qui est multiple de la fréquence d'échantillonnage.

6. Système selon la revendication 3, caractérisé en ce que les moyens (12, 13) pour enregistrer les valeurs des grandeurs au cours de la ou desdites évolutions sont constitués par des tables de correspondance, enregistrées en mémoire.

7. Système selon la revendication 4, caractérisé en ce que les moyens de multiplication (14) sont constitués par des tables de multiplication par des coefficients, enregistrées en mémoire.

**Patentansprüche**

1. Verfahren zur Registrierung und Veranschaulichung von zeitvariablen physikalischen Größen (x, y), enthaltend: Registrieren der Werte (x = f(t), y = g(t)) einer jeden der Größen im Verlaufe der Zeit mit wenigstens einer vorbestimmten Abtast- oder Zugriffsfrequenz, gekennzeichnet durch gleichzeitiges Registrieren der Entwicklung der Werte einer dieser Größen gegenüber der Entwicklung der Werte der anderen der Größen (x = h(y)) und/oder der Entwicklung der Werte der einen dieser Größen gegenüber der Entwicklung der Werte der anderen dieser Größen als Funktion der Zeit (x = e(y, t)) mit der gleichen Abtastfrequenz, wobei das Verfahren anschließend darin besteht, den oder die Graph(e), der bzw. die für die Entwicklung(en) repräsentativ ist (sind), sichtbar zu machen, wobei der oder die Graph(e) ausgehend von den registrierten Werten sichtbar gemacht werden, die im Speicher mit derselben Frequenz ausgewählt werden, wie die genannte vorbestimmte Abtastfrequenz, oder ausgehend von einigen der registrierten Werte sichtbar gemacht werden, die im Speicher mit einer Auswahlfrequenz ausgewählt werden, die ein Mehrfaches der Abtastfrequenz ist.

2. Verfahren nach Anspruch 1, dadurch gekennzeichnet, daß weiterhin jedem der registrierten Werte Größen zugeordnet werden und vor der Veranschaulichung Multiplikationskoeffizienten zugeordnet werden, um in Relation mit der Auswahl eines jeden dieser Koeffizienten einen vorbestimmten Veranschaulichungsmaßstab des oder der Graph(e) zu erhalten.

3. System zur Veranschaulichung von zeitvariablen physikalischen Größen (x, y), enthaltend einen Rechner (1), einen Speicher (2), in welchem die Größenwerte gespeichert sind und der mit diesem Rechner verbunden ist, einen Taktgenerator (3) mit einstellbarer Frequenz, der mit Zugriffseinrichtungen (4) für die Werte dieser Größen verbunden ist, um wenigstens eine Abtast- oder Zugriffsfrequenz der Größenwerte festzulegen, wobei Ausgänge dieser Zugriffseinrichtungen (4) mit dem Rechner (1) verbunden sind und Veranschaulichungseinrichtungen (7) mit dem Rechner verbunden sind, dadurch gekennzeichnet, daß es weiterhin Einrichtungen (12, 13) aufweist, die mit dem Rechner verbunden sind, um die gleichzeitige Einspeicherung der Entwicklung der Werte einer dieser Größen gegenüber der Entwicklung der Werte der anderen dieser Größen (x = h(y)) oder die Entwicklung der Werte einer dieser Größen gegenüber der Entwicklung der Werte einer anderen dieser Größen in Abhängigkeit von der Zeit (x = e(y, t)) mit derselben Abtastfrequenz in den Speicher (2) zu steuern, wobei der Rechner (1) die Veranschaulichungseinrichtungen (7) steuert, um das Abbild des oder der Graph(e) zu erhalten, der bzw. die für die Entwicklung(en) repräsentativ ist (sind), ausgehend von den genannten gespeicherten Werten.

4. System nach Anspruch 3, dadurch gekennzeichnet, daß es weiterhin Einrichtungen (14) enthält, um jedem der gespeicherten Werte vor der Veranschaulichung Multiplikationskoeffizienten hinzuzufügen, um in Relation mit der Wahl eines jeden der Koeffizienten einen vorbestimmten Veranschaulichungsmaßstab des oder der Graph(e) zu erhalten.

5. System nach Anspruch 3, dadurch gekennzeichnet, daß der regelbare Taktgenerator (3) weiterhin mit dem Rechner (1) verbunden ist, um die Auswahlfrequenz der gespeicherten Werte für die Veranschaulichung des oder der Graph(e) festzulegen, wobei diese Werte im Speicher mit einer Auswahlfrequenz ausgewählt werden, die gleich der vorbestimmten Abtastfrequenz ist, oder mit einer Auswahlfrequenz ausgewählt werden, die ein Vielfaches der Abtastfrequenz ist.

6. System nach Anspruch 3, dadurch gekennzeichnet, daß die Einrichtungen (12, 13) zum Speichern der Werte der Größen im Verlaufe der genannten Entwicklung(en) durch Korrespondenztabellen gebildet sind, die im Speicher gespeichert sind.

7. System nach Anspruch 4, dadurch gekennzeichnet, daß die Multiplikationseinrichtungen (14) durch Multiplikationstabellen nach Koeffizienten gebildet sind, die im Speicher gespeichert sind.

**Claims**

1. Process for recording and displaying physical quantities (x, y) which are variable in time and consisting of recording, with at least one predetermined sampling or acquisition frequency, the values (x = f(t), y = g(t)) of each of these quantities during a period of time and characterized in that it comprises simultaneously recording at the same sampling frequency, the development of the values of one of these quantities compared with the development of the values of the other of these quantities (x = h(y)) and/or the development of the values of one of these quantities compared with the development of the values of another of these quantities as a function of time (x = e(y,t)), the process then consisting of displaying the graph or graphs representing the said development or developments, the graph or graphs being displayed on the basis of recorded values, selected in the memory at the same frequency as said predetermined sampling frequency, or on the basis of certain of the recorded values selected in the memory at a selection frequency which is a multiple of the sampling frequency.

2. Process according to claim 1, characterized in that it also comprises applying multiplication factors to each of these values or quantities during said development or developments, in order to obtain a predetermined display scale of the graphs in relation to the choice of each of these factors.

3. System for the display of physical quantities (x, y) which are variable in time, comprising a computer (1), a memory (2) in which are recorded the values of the quantities and connected to said computer, a regulatable frequency clock (3) connected to said means (4) for the acquisition of the values of said quantities for fixing at least one sampling or acquisition frequency of the values of said quantities, outputs of said acquisition means (4) being connected to the computer (1), and display means (7) connected to the computer, characterized in that it also comprises means (12, 13) connected to the computer for controlling the simultaneous recording in the computer memory (2) and at the same sampling frequency the development of the values of one of these quantities compared with the development of the values of another of these quantities (x = h(y)), or the development of the values of one of these quantities compared with the development of the values of another of these quantities as a function of time (x = (y, t)), the computer (1) controlling the display means (7) for obtaining the image of the graph or graphs representing said development or developments on the basis of said recorded values.

4. System according to claim 3, characterized in that it also comprises means (14) for applying to each of these recorded values and prior to display, multiplication factors for obtaining, in relation to the choice of each of these factors, a predetermined display scale of the graph or graphs.

5. System according to claim 3, characterized in that the regulatable clock (3) is also connected to the computer (1) for fixing the selection frequency of the recorded values for the display of the graph or graphs, said values being selected in the memory with a selection frequency equal to the predetermined sampling frequency, or with a selection frequency which is a multiple of the sampling frequency.

6. System according to claim 3, characterized in that the means (12, 13) for recording the values of the quantities during said development or developments are constituted by correspondence tables recorded in the memory.

7. System according to claim 4, characterized in that the multiplication means (14) are constituted by factor multiplication tables recorded in the memory.